# EUROPÄISCHE PATENTSCHRIFT

(11) **EP 3 276 412 B1**
(45) Veröffentlichungstag und Bekanntmachung des Hinweises auf die Patenterteilung: **27.11.2019**
(21) Anmeldenummer: 17182818.9
(22) Anmeldetag: 24.07.2017
(51) Int. Cl.: G03B 43/00, G03B 17/12, G02B 27/62

(54) **OBJEKTSIMULATIONSGERÄT ZUM PRÜFEN EINES KAMERAOBJEKTIVS UND DIAGNOSESYSTEM**
OBJECT SIMULATING APPARATUS FOR TESTING A CAMERA LENS AND DIAGNOSTIC SYSTEM
APPAREIL DE SIMULATION D'OBJET DESTINÉ À CONTRÔLER UN OBJECTIF DE CAMÉRA ET SYSTÈME DE DIAGNOSTIC

(30) Priorität: 27.07.2016 DE 102016113887
(43) Veröffentlichungstag der Anmeldung: 31.01.2018
(73) Patentinhaber: Arnold&Richter Cine Technik GmbH&Co. Betriebs KG, 80799 München (DE)
(72) Erfinder: Fiebig, Susanne, 85521 Ottobrunn (DE)
(74) Vertreter: Manitz Finsterwald Patent- und Rechtsanwaltspartnerschaft mbB

(56) Entgegenhaltungen:
- WO-A1-2013/102555
- DE-A1-102011 076 133
- DE-A1-102011 078 631
- JP-A- 2005 016 981
- US-A1- 2016 134 796

## Beschreibung

Die vorliegende Erfindung betrifft ein Objektsimulationsgerät zum Prüfen eines Kameraobjektivs, wobei das Objektsimulationsgerät eine optische Achse und an einem Ende bezüglich der optischen Achse eine Vorderseite aufweist. Das Objektsimulationsgerät weist an seiner Vorderseite eine Lichtaustrittsfläche sowie eine Kopplungseinrichtung auf, die dazu angepasst ist, die Vorderseite des Objektsimulationsgeräts an eine Lichteintrittsseite eines Kameraobjektivs zu koppeln. Weiterhin ist eine Lichtbündelerzeugungseinrichtung vorgesehen. Die vorliegende Erfindung betrifft ferner ein Diagnosesystem mit einem derartigen Objektsimulationsgerät.

Kameras, insbesondere digitale Stillbildkameras bzw. digitale Videokameras, sind oftmals für einen Betrieb mit Wechselobjektiven ausgelegt. Die Kamera weist in diesem Fall einen Bildsensor und eine Objektivhalterung zum Anschließen eines Objektivs (d.h. einer Linsenanordnung in einem separaten Gehäuse) auf, wobei der Bildsensor und das Objektiv längs einer optischen Achse der Kamera angeordnet sind.

Die Objektivhalterung definiert eine Auflageebene für das anzuschließende Objektiv. Die lichtempfindliche Fläche des Bildsensors definiert eine Sensorebene. In der Regel entsprechen die Auflageebene und die Sensorebene einer jeweiligen Orthogonalebene zu der optischen Achse der Kamera. Der Abstand zwischen der Auflageebene und der Sensorebene bildet das sogenannte Auflagemaß der Kamera. Entsprechend ist auch für das Kameraobjektiv ein Auflagemaß definiert. Da das optische Design eines jeweiligen Objektivs auf eine bestimmte Position des Sensors zu den optischen Elementen des Objektivs hin berechnet ist, müssen der optische Abstand zwischen der Auflageebene und dem Bildsensor sowie das sich aus dem Abstand der optischen Elemente zur Auflageebene ergebende Auflagemaß des Objektivs übereinstimmen. Andernfalls ergeben sich Abweichungen zwischen einem eingestellten Entfernungswert gemäß einer Entfernungsskala des Objektivs und der tatsächlichen Entfernung des abzubildenden Objekts.

Zum Einstellen der Bildschärfe ist am Objektiv nämlich oftmals ein manuell oder motorisch betriebener Fokusmechanismus, insbesondere ein drehbarer Objektiv- oder Fokusring, vorgesehen, welcher mit einer Entfernungsskala versehen ist. Damit ein Objekt, das sich in einer Entfernung befindet, welche dem eingestellten Entfernungswert auf der Entfernungsskala entspricht, tatsächlich auch scharf abgebildet wird, ist es also erforderlich, dass das tatsächliche Auflagemaß demjenigen Auflagemaß entspricht, für welches das jeweilige Objektiv konzipiert wurde.

Das tatsächliche Auflagemaß kann von verschiedenen Rahmenbedingungen im Betrieb der Kamera abhängen, so dass mitunter Abweichungen zwischen dem eingestellten Entfernungswert gemäß Entfernungsskala des Objekts und der tatsächlichen Entfernung des abzubildenden Objekts auftreten können und/oder keine optimale Fokussierung erfolgt. Insbesondere besteht eine mögliche Fehlerquelle auch darin, dass das Auflagemaß der Kamera und das Auflagemaß des Objektivs getrennt überprüft und eingestellt werden können.

Für eine Überprüfung der Entfernungsskala bzw. des Auflagemaßes eines Objektivs kann ein Testprojektor verwendet werden, welcher ein Testdia in umgekehrtem Strahlengang von hinten durch das Objektiv auf eine Projektionsfläche projiziert. Durch eine Abstandsänderung zwischen dem Projektor und der Projektionsfläche bzw. durch ein Verstellen der Fokusentfernung am zu überprüfenden Objektiv lassen sich Abweichungen zwischen der eingestellten Entfernung und der tatsächlichen Entfernung bzw. das Auflagemaß bestimmen. Derartige Testprojektoren bieten jedoch nur einen begrenzten Entfernungsmessbereich. Außerdem wird nur das Auflagemaß des Objektivs getestet, nicht jedoch das Auflagemaß der Kamera. Letzteres muss also separat gemessen werden, was eine erhebliche Fehlerquelle darstellt.

Des Weiteren existieren diverse auf Kollimatoren basierende Geräte zur Messung des Auflagemaßes von Objektiven. Diese können jedoch lediglich ein auf "unendlich" fokussiertes Objektiv testen. Außerdem muss auch hier das Auflagemaß der Kamera separat gemessen werden.

Das Auflagemaß bzw. eine Abweichung der Fokuslage lässt sich auch mit Hilfe eines als MTF-Gerät (MTF von "modulation transfer function", englisch für Kontrastübertragungsfunktion) bezeichneten Gerätes zur Messung des Objektivkontrastes ermitteln. Derartige MTF-Geräte sind jedoch oftmals sehr große, teure und komplexe Geräte mit entsprechenden Anforderungen an Umgebung, Bedienung und Wartung. Das Auflagemaß der Kamera muss wiederum getrennt von dem Auflagemaß des Objektivs gemessen werden.

Das Dokument US 2016/0134796 A1 offenbart ein Objektsimulationsgerät mit den Merkmalen des Oberbegriffs des Anspruchs 1. Die Dokumente DE 10 2011 078 631 A1, JP 2005 016981 A, DE 10 2011 076 133 A1 und WO 2013/102555 A1 offenbaren weitere Objektsimulationsgeräte bzw. Kameraprüfgeräte.

Es ist die Aufgabe der Erfindung, ein Objektsimulationsgerät und ein Diagnosesystem zu schaffen, mit deren Hilfe das Auflagemaß bzw. die Fokuslage eines Kameraobjektivs und/oder eines Objektiv-Kamera-Systems einfach und kostengünstig ermittelt werden kann.

Die Lösung der Aufgabe erfolgt durch ein Objektsimulationsgerät mit den Merkmalen des Anspruchs 1.

Das Objektsimulationsgerät umfasst eine Lichtaustrittsfläche an der Vorderseite des Objektsimulationsgeräts, eine Kopplungseinrichtung, die dazu angepasst ist, die Vorderseite des Objektsimulationsgeräts an eine Lichteintrittsseite eines Kameraobjektivs zu koppeln, und eine Lichtbündelerzeugungseinrichtung, die wenigstens eine Lichtquelle aufweist und die dazu angepasst ist, wenigstens ein Lichtbündel zu erzeugen, das die Lichtaustrittsfläche derart passiert, dass das wenigstens eine Lichtbündel scheinbar von einem oder mehreren virtuellen Objekt(en) ausgeht, welche(s) sich in einer Distanz zu der Lichtaustrittsfläche befindet bzw. befinden, die größer ist als die Distanz zwischen der Lichtbündelerzeugungseinrichtung und der Lichtaustrittsfläche.

Das wenigstens eine virtuelle Objekt kann sich insbesondere in einer Distanz zu der Lichtaustrittsfläche befinden, die größer ist als die Distanz zwischen der Lichtquelle der Lichtbündelerzeugungseinrichtung und der Lichtaustrittsfläche. Die jeweilige virtuelle Lichtquelle bzw. das jeweilige virtuelle Objekt kann insbesondere (scheinbar) außerhalb des Objektsimulationsgeräts, d.h. jenseits einer Rückseite des Objektsimulationsgeräts, angeordnet sein. Die Lichtbündelerzeugungseinrichtung kann gleichwohl nahe der Frontlinse des zu überprüfenden Objektivs vorgesehen sein, so dass das Objektsimulationsgerät sehr kompakt gebaut werden kann.

Die Lichtaustrittsfläche des Objektsimulationsgeräts kann ein oder mehrere Lichtaustrittsfenster umfassen. Die Lichtaustrittsfläche kann sich insbesondere senkrecht zu der optischen Achse des Objektsimulationsgeräts erstrecken. Die genannte Kopplungseinrichtung kann die Lichtaustrittsfläche umfänglich umgeben und kann beispielsweise einen Bajonettverschluss, Schraubverschluss oder Klemmverschluss umfassen. Die genannte Distanz zwischen dem virtuellen Objekt und der Lichtaustrittsfläche kann insbesondere größer als die Erstreckung des Objektsimulationsgeräts entlang der optischen Achse sein. Dadurch kann das Objektsimulationsgerät insbesondere die Überprüfung von Entfernungswerten gestatten, die wesentlich größer sind als die Abmessungen des Objektsimulationsgeräts selbst.

Bei dem Objektsimulationsgerät kann ein jeweiliges Lichtbündel die Lichtaustrittsfläche in einem lateralen Austrittsabstand zur optischen Achse und entlang einer Lichtaustrittsachse passieren, die bezüglich der optischen Achse um einen Austrittswinkel geneigt ist, wobei der Austrittsabstand und der Austrittswinkel von Null verschieden sind und wobei der Austrittsabstand und der Austrittswinkel (geometrisch) einer virtuellen Lichtquelle entsprechen. Diese virtuelle Lichtquelle befindet sich in einer größeren Distanz als die tatsächliche Lichtquelle, insbesondere außerhalb des Objektsimulationsgeräts, d.h. jenseits einer Rückseite des Objektsimulationsgeräts. Unter einem Lichtbündel wird hier nicht zwingend ein Bündel von parallelen Lichtstrahlen oder nur ein auf eine Linie begrenzter Lichtstrahl verstanden, sondern kann insbesondere auch ein divergentes Strahlbündel umfassen.

Die Lichtbündelerzeugungseinrichtung umfasst mehrere Lichtquellen.

Gemäß einer ersten erfindungsgemäßen Alternative ist die Position und/oder die Ausrichtung der mehreren Lichtquellen derart verstellbar, dass durch ein Verstellen der mehreren Lichtquellen die Distanz zwischen dem virtuellen Objekt und der Lichtaustrittsfläche des Objektsimulationsgeräts veränderbar ist.

Gemäß einer zweiten erfindungsgemäßen Alternative kann die Lichtbündelerzeugungseinrichtung ferner mehrere Abbildungselemente aufweisen, wobei jeder der mehreren Lichtquellen wenigstens eines der mehreren Abbildungselemente zugeordnet ist. Insbesondere kann jeder der mehreren Lichtquellen genau eines der mehreren Abbildungselemente zugeordnet sein. Die Position und/oder die Ausrichtung der mehreren Abbildungselemente ist derart verstellbar, dass durch ein Verstellen der mehreren Abbildungselemente die Distanz zwischen dem virtuellen Objekt und der Lichtaustrittsfläche des Objektsimulationsgeräts veränderbar ist. Insbesondere können die mehreren Abbildungselemente derart verstellbar sein, dass sich hierdurch der Winkel der bereits genannten Lichtaustrittsachsen in Bezug auf die optische Achse des Objektsimulationsgeräts verändert. Es kann vorgesehen sein, dass die Abbildungselemente unabhängig von der jeweiligen Lichtquelle verstellbar sind. Alternativ kann vorgesehen sein, dass jedes der mehreren Abbildungselemente gemeinsam mit der jeweiligen Lichtquelle verstellbar ist. Ferner ist es möglich, dass einige oder sämtliche der mehreren Abbildungselemente gemeinsam verstellbar sind, insbesondere mittels einer gemeinsamen Antriebseinrichtung.

Das Verstellen kann auf verschiedene Weise erfolgen (alternativ zueinander oder auch in Kombination). So kann beispielsweise ein Verschwenken der Lichtquellen, insbesondere gemeinsam mit einem jeweiligen Abbildungselement vorgesehen sein, wobei als Lichtquelle beispielsweise ein Laser oder eine andere Lichtquelle mit einer fest zugeordneten Linse vorgesehen sein kann. Weiterhin können die Lichtquellen, insbesondere gemeinsam mit einem jeweils zugeordneten Abbildungselement, d.h. als Einheit von Lichtquelle und Optik, lateral zu der optischen Achse, insbesondere senkrecht zu dieser, versetzt werden. Ferner kann das Verstellen der Lichtquellen und/oder der Abbildungselemente auch eine Kombination aus Verschwenken und Versetzen umfassen.

Darüber hinaus kann ein Verstellen zum Ändern der Distanz auch darin bestehen, dass entweder nur die Lichtquellen oder nur die Abbildungselemente verschwenkt werden und/oder lateral zur optischen Achse und/oder in Richtung der optischen Achse versetzt werden.

Nach einer vorteilhaften Ausführungsform entspricht das virtuelle Objekt zumindest im Wesentlichen einer virtuellen Punktlichtquelle. Hierdurch vereinfacht sich die Auswertung, ob das Kameraobjektiv auf das virtuelle Objekt fokussiert ist, da hierzu beispielsweise lediglich der Durchmesser eines oder mehrerer auf dem Bildsensor erzeugter Abbilder des virtuellen Objekts untersucht werden muss, wobei das oder die Abbilder bei exakter Fokussierung punktförmig sein oder einen minimalen Durchmesser aufweisen sollten.

Alternativ hierzu kann das virtuelle Objekt einer linienförmigen virtuellen Lichtquelle entsprechen, die sich innerhalb einer Orthogonalebene zu der optischen Achse erstreckt. Insbesondere kann eine geradlinige virtuelle Lichtquelle vorgesehen sein.

Weiterhin ist es auch möglich, dass das virtuelle Objekt einer zweidimensionalen, d.h. flächigen virtuellen Lichtquelle entspricht, die sich innerhalb einer Orthogonalebene zu der optischen Achse des Objektsimulationsgeräts erstreckt.

Die Auswertung, ob das Kameraobjektiv auf das virtuelle Objekt fokussiert ist, kann beispielsweise auf der Grundlage einer Kantenunschärfe des virtuellen Objekts erfolgen.

Gemäß einer weiteren Ausführungsform kann die Lichtbündelerzeugungseinrichtung dazu angepasst sein, zeitlich nacheinander ein jeweiliges virtuelles Objekt auf der optischen Achse in verschiedenen Distanzen zu der Lichtaustrittsfläche des Objektsimulationsgeräts zu erzeugen bzw. zu simulieren, also an verschiedenen Positionen entlang der optischen Achse. Alternativ oder zusätzlich kann die Lichtbündelerzeugungseinrichtung dazu angepasst sein, gleichzeitig mehrere virtuelle Objekte innerhalb einer gemeinsamen Orthogonalebene zu der optischen Achse zu erzeugen. Ferner kann die Lichtbündelerzeugungseinrichtung dazu angepasst sein, gleichzeitig mehrere virtuelle Objekte in unterschiedlichem lateralen Abstand zu der optischen Achse zu erzeugen.

Bei dem Objektsimulationsgerät kann also die Distanz zwischen dem jeweiligen virtuellen Objekt und der Lichtaustrittsfläche des Objektsimulationsgeräts einstellbar sein. Das Einstellen der Distanz kann insbesondere durch ein entsprechendes Verstellen der Lichtbündelerzeugungseinrichtung oder eines Teils hiervon erfolgen. Beispielsweise kann ein Verschwenken von Lichtquellen und/oder zugeordneten Abbildungselementen vorgesehen sein. Vorzugsweise erfolgt das Einstellen verschiedener Distanzen nacheinander, so dass für jede eingestellte Distanz des virtuellen Objekts eine separate Diagnose eines angekoppelten Kameraobjektivs bzw. eines angekoppelten Objektiv-Kamera-Systems durchgeführt werden kann.

Zum Einstellen verschiedener Distanzen des jeweiligen virtuellen Objekts kann vorgesehen sein, dass das wenigstens eine Lichtbündel die Lichtaustrittsfläche des Objektsimulationsgeräts entlang einer Lichtaustrittsachse passiert, die bezüglich der optischen Achse um einen Austrittswinkel geneigt ist, wobei der Austrittswinkel einstellbar ist.

Gemäß einer weiteren Ausführungsform kann vorgesehen sein, dass der laterale Abstand des wenigstens einen virtuellen Objekts zu der optischen Achse des Objektsimulationsgeräts einstellbar ist.

In entsprechender Weise können, wenn mehrere Lichtbündel die Lichtaustrittsfläche des Objektsimulationsgeräts passieren, die Austrittswinkel der mehreren Lichtbündel und/oder der jeweilige laterale Austrittsabstand der mehreren Lichtbündel einstellbar sein.

Für das Einstellen verschiedener Distanzen des jeweiligen virtuellen Objekts, beispielsweise durch Verstellen der Position und/oder der Ausrichtung einer jeweiligen Lichtquellen und/oder eines jeweiligen Abbildungselements, kann das Objektsimulationsgerät gemäß einer vorteilhaften Ausführungsform wenigstens eine elektrisch ansteuerbare Antriebseinrichtung aufweisen.

Es kann vorgesehen sein, dass die Lichtbündelerzeugungseinrichtung dazu angepasst ist, mehrere Lichtbündel zu erzeugen, welche die Lichtaustrittsfläche des Objektsimulationsgeräts passieren. Die mehreren Lichtbündel können die die Lichtaustrittsfläche insbesondere entlang einer jeweiligen Lichtaustrittsachse passieren. Die Winkelausrichtungen der Lichtaustrittsachsen von einigen oder sämtlichen der mehreren Lichtbündel können unterschiedlich sein. Die Lichtaustrittsachsen der mehreren Lichtbündel können insbesondere derart ausgerichtet sein, dass die mehreren Lichtbündel von dem wenigstens einen virtuellen Objekt, d.h. von dem einen oder den mehreren virtuellen Objekt(en) auszugehen scheinen. Wie nachstehend noch erläutert wird, können beispielsweise mehrere virtuelle Objekte vorgesehen sein, wobei jeweils ein Lichtbündel scheinbar von jeweils einem der mehreren virtuellen Objekte ausgeht. Oder es kann vorgesehen sein, dass sämtliche der mehreren Lichtbündel scheinbar von demselben virtuellen Objekt ausgehen. Oder es kann auch vorgesehen sein, dass von mehreren virtuellen Objekten scheinbar jeweils mehrere Lichtbündel ausgehen.

Insbesondere können die mehreren Lichtbündel die Lichtaustrittsfläche des Objektsimulationsgeräts in einem jeweiligen Austrittsabstand zu der optischen Achse und entlang einer jeweiligen Lichtaustrittsachse passieren, die bezüglich der optischen Achse um einen jeweiligen Austrittswinkel geneigt ist, wobei die Austrittsabstände und Austrittswinkel der mehreren Lichtbündel die Position des wenigstens einen virtuellen Objekts definieren.

Die Lichtaustrittsachsen der mehreren Lichtbündel können insbesondere derart ausgerichtet sein, dass die Lichtbündel von einem oder mehreren virtuellen Objekten auszugehen scheinen, wobei die jeweilige Position des virtuellen Objekts oder der virtuellen Objekte durch die Schnittpunkte der von der Lichtaustrittsfläche in Richtung des Objektsimulationsgeräts gedachten Verlängerungen der Lichtbündel gebildet wird.

Demnach sind bei dieser Ausführungsform also mehrere Lichtbündel vorgesehen, die von einer oder mehreren Lichtquellen erzeugt werden. Die Lichtbündelerzeugungseinrichtung kann die mehreren Lichtbündel gleichzeitig oder nacheinander erzeugen, z.B. um verschiedene Distanzen des virtuellen Objekts oder unterschiedliche Bildhöhen bei gleicher Distanz zu simulieren. Die Lichtaustrittsachsen können in unterschiedliche Richtungen verlaufen.

Gemäß einer Ausgestaltung sind die Lichtaustrittsachsen der mehreren Lichtbündel derart ausgerichtet, dass die mehreren Lichtbündel von einem einzigen virtuellen Objekt auszugehen scheinen. Dieses einzige virtuelle Objekt liegt vorzugsweise auf der optischen Achse des Objektsimulationsgeräts.

Alternativ hierzu ist es auch möglich, dass die mehreren Lichtbündel die Lichtaustrittsfläche des Objektsimulationsgeräts entlang einer jeweiligen Lichtaustrittsachse passieren, wobei die Lichtaustrittsachsen derart ausgerichtet sind, dass die mehreren Lichtbündel von verschiedenen virtuellen Objekten auszugehen scheinen. Hierdurch können mehrere virtuelle Objekte erzeugt werden. Dabei können - insbesondere wenn mehrere virtuelle Objekte gleichzeitig erzeugt werden - zumindest einige der mehreren virtuellen Objekte innerhalb derselben Orthogonalebene zu der optischen Achse und/oder bezüglich der optischen Achse in Umfangsrichtung verteilt und/oder in unterschiedlichem lateralen Abstand zur optischen Achse angeordnet sein. Alternativ können - insbesondere wenn mehrere virtuelle Objekte zeitlich nacheinander erzeugt werden - zumindest einige der mehreren virtuellen Objekte in unterschiedlicher Distanz zu der Lichtaustrittsfläche des Objektsimulationsgeräts angeordnet sein.

Gemäß einer weiteren Ausführungsform sind zumindest einige der mehreren Lichtbündel bezüglich der optischen Achse in Umfangsrichtung verteilt angeordnet.

Alternativ oder zusätzlich können zumindest einige der mehreren Lichtbündel die Lichtaustrittsfläche in einem unterschiedlichen lateralen Austrittsabstand zu der optischen Achse passieren.

Nach einer anderen vorteilhaften Ausführungsform sind die mehreren Lichtbündel separat voneinander. Die separaten Lichtbündel sind vorzugsweise voneinander beabstandet. Dadurch vereinfacht sich die Auswertung, ob das Kameraobjektiv auf das virtuelle Objekt fokussiert ist, denn nur im Fokus sind in einem vom Kameraobjektiv erzeugten Abbild eines beispielsweise punktförmigen virtuellen Objekts alle Lichtbündel in einem Lichtfleck vereint. Bei defokussiertem Objektiv existieren ansonsten mehrere voneinander beabstandete oder zumindest unterscheidbare Lichtflecke.

Alternativ hierzu können die mehreren Lichtbündel gemeinsam ein einheitliches Strahlbündel bilden. Darunter ist zu verstehen, dass die mehreren Lichtbündel kontinuierlich bzw. ununterscheidbar ineinander übergehen können, zum Beispiel in Form eines Kegels.

Ein besonderer Vorteil der Ausführungsform mit mehreren Lichtbündeln besteht darin, dass diese nicht zwingend die gesamte Eintrittspupille des Kameraobjektivs ausfüllen müssen. Sondern es ist generell ausreichend, wenn die Lichtbündel nur einen Teil der Objektivblende ausfüllen, wobei hierdurch eine Fokuslage äquivalent zu der Fokuslage einer vollständig ausgefüllten Objektivblende simuliert wird. Beispielsweise können die Lichtbündel derart erzeugt werden bzw. die Lichtaustrittsfläche des Objektsimulationsgeräts passieren, dass sie in dem Kameraobjektiv bezogen auf die optische Achse des Kameraobjektivs nur in einem radial begrenzten Bereich (z.B. achsnah) und/oder in Umfangsrichtung voneinander beabstandet angeordnet sind.

Gemäß einer Ausführungsform kann die Lichtbündelerzeugungseinrichtung allerdings auch dazu angepasst sein, mehrere Lichtbündel zu erzeugen, welche die Lichtaustrittsfläche des Objektsimulationsgeräts an Austrittsstellen passieren, die zumindest im Wesentlichen über die gesamte Lichtaustrittsfläche verteilt sind. Hierdurch können die Lichtbündel eine Eintrittspupille des Kameraobjektivs zumindest im Wesentlichen vollständig ausfüllen, damit bezogen auf die optische Achse des Kameraobjektivs sowohl achsnahe als auch achsferne Strahlengänge sowie Strahlengänge in mehreren Umfangswinkelbereichen für die Diagnose des Auflagemaßes berücksichtigt werden.

Gemäß einer weiteren Ausführungsform kann das jeweilige Abbildungselement refraktiver, reflektiver oder diffraktiver Art sein. Das jeweilige Abbildungselement kann - von der Lichtaustrittsfläche aus in Richtung der Lichtquelle gesehen - insbesondere hinter der Lichtaustrittsfläche des Objektsimulationsgeräts angeordnet sein, oder das jeweilige Abbildungselement kann durch die Lichtaustrittsfläche gebildet werden. Die wenigstens eine Lichtquelle ist bei Verwendung eines refraktiven oder diffraktiven Abbildungselements (z.B. einer Linse) - von der Lichtaustrittsfläche aus gesehen - vorzugsweise hinter dem Abbildungselement angeordnet, bei Verwendung eines reflektiven Abbildungselements (z.B. eines Hohlspiegels) vor dem Abbildungselement bis zu der Brennebene des reflektiven Abbildungselements.

Zumindest einigen von mehreren Lichtbündeln und/oder mehreren Lichtquellen kann ein gemeinsames Abbildungselement zugeordnet sein. Alternativ können mehrere Abbildungselemente vorgesehen sein, wobei jedem einzelnen von mehreren Lichtbündeln und/oder jeder einzelnen von mehreren Lichtquellen ein eigenes Abbildungselement (d.h. ein anderes Abbildungselement) zugeordnet sein kann.

Gemäß einer Ausführungsform kann die Lichtbündelerzeugungseinrichtung dazu angepasst sein, mehrere Lichtbündel zu erzeugen, welche die Lichtaustrittsfläche des Objektsimulationsgeräts passieren, wobei jede der mehreren Lichtquellen wenigstens eines der mehreren Lichtbündel erzeugt (d.h. genau eines oder einige der mehreren Lichtbündel). Es ist auch möglich, dass jede der mehreren Lichtquellen ein einziges der mehreren Lichtbündel erzeugt (d.h. jede der mehreren Lichtquellen erzeugt ein anderes der mehreren Lichtbündel).

In dem Zusammenhang hat es sich als vorteilhaft erwiesen, wenn die mehreren Lichtquellen innerhalb derselben Orthogonalebene zu der optischen Achse angeordnet sind (d.h. innerhalb einer gemeinsamen Ebene, die senkrecht zu der optischen Achse des Objektsimulationsgeräts steht). Alternativ können mehrere Lichtquellen in unterschiedlicher Distanz zu der Lichtaustrittsfläche des Objektsimulationsgeräts angeordnet sein.

Nach einer Ausführungsform können zumindest einige der mehreren Lichtquellen bezüglich der optischen Achse in Umfangsrichtung verteilt angeordnet sein.

Alternativ oder zusätzlich können zumindest einige der mehreren Lichtquellen in unterschiedlichem Abstand zu der optischen Achse angeordnet sein.

Die Lichtbündel der mehreren Lichtquellen können die Lichtaustrittsfläche des Objektsimulationsgeräts entlang einer jeweiligen Lichtaustrittsachse passieren, wobei die Position des virtuellen Objekts insbesondere durch die Ausrichtungen der Lichtaustrittsachsen festgelegt sein kann.

Gemäß noch einer weiteren vorteilhaften Ausführungsform kann die Lichtbündelerzeugungseinrichtung (mit mehreren Lichtquellen) wenigstens eine Blendenvorrichtung umfassen, wobei die Blendenvorrichtung eine oder mehrere bezüglich ihrer Öffnungsweite und/oder Position variable Blendenöffnung(en) aufweisen kann, welche Teile des von der wenigstens eine Lichtquelle emittierten Lichts durchlässt bzw. durchlassen.

Gemäß einer weiteren vorteilhaften Ausführungsform kann die wenigstens eine Lichtquelle weißes Licht emittieren, so dass das wenigstens eine Lichtbündel weißes Licht enthält oder aus weißem Licht besteht. Hierdurch kann die Diagnose eines angekoppelten Kameraobjektivs inhärent über einen Wellenlängenbereich erfolgen, der zumindest im Wesentlichen das gesamte sichtbare Spektrum umfasst.

Allerdings kann die Lichtbündelerzeugungseinrichtung auch dazu angepasst sein, das wenigstens eine Lichtbündel mit einer von mehreren verschiedenen auswählbaren Farben zu erzeugen. Mit anderen Worten kann bei dieser Ausführungsform eine von mehreren Farben, d.h. einer von mehreren begrenzten Wellenlängenbereichen innerhalb des sichtbaren Spektrums, ausgewählt werden, wobei die Diagnose eines angekoppelten Kameraobjektivs nur für diese Farbe (z.B. Rot) erfolgt. Danach kann eine weitere Diagnose für eine oder mehrere andere Farben (z.B. Grün oder Blau) durchgeführt werden. Somit kann eine wellenlängenabhängige Diagnose des Kameraobjektivs erfolgen, insbesondere zur Ermittlung von wellenlängenabhängigen Korrekturwerten, zur Untersuchung von Farbfehlern des Kameraobjektivs und/oder zur Vermeidung von chromatischen Aberrationen bei der Erzeugung des virtuellen Objekts.

Gemäß einer Ausführungsform kann die wenigstens eine Lichtquelle einstellbar sowohl weißes Licht als auch farbiges Licht emittieren, insbesondere in jeweils einer der Farben Rot, Grün und Blau.

Die vorliegende Erfindung betrifft ferner ein Diagnosesystem mit einem Objektsimulationsgerät nach einer der vorstehend erläuterten Ausführungsformen und mit einer Auswerteeinrichtung, die dazu angepasst ist, einen Fokusgrad eines Abbildes des wenigstens einen virtuellen Objekts zu ermitteln, das von dem an das Objektsimulationsgerät gekoppelten jeweiligen Kameraobjektiv erzeugt wird. Sofern also ein zu prüfendes Kameraobjektiv mit dem Objektsimulationsgerät gekoppelt wird, kann das Kameraobjektiv ein Abbild des mittels des Objektsimulationsgeräts simulierten virtuellen Objekts erzeugen, und die Auswerteeinrichtung wertet das erzeugte Abbild des virtuellen Objekts hinsichtlich des Fokusgrades aus.

Gemäß einer Ausführungsform umfasst das Diagnosesystem auch eine Bildaufnahmevorrichtung, wobei die Bildaufnahmevorrichtung eine Kopplungseinrichtung aufweist, die dazu angepasst ist, eine Lichteintrittsseite der Bildaufnahmevorrichtung an eine Lichtaustrittsseite des Kameraobjektivs zu koppeln, wobei die Bildaufnahmevorrichtung ferner einen Bildsensor zum Erzeugen elektrischer Bildsignale auf der Grundlage eines von dem Kameraobjektiv auf dem Bildsensor erzeugten Abbildes des virtuellen Objekts aufweist. Die genannte Auswerteeinrichtung kann direkt oder indirekt mit dem Bildsensor verbunden oder verbindbar sein. Die Kopplungseinrichtung kann beispielsweise einen Bajonettverschluss, Schraubverschluss oder Klemmverschluss umfassen.

Bei der genannten Bildaufnahmevorrichtung kann es sich insbesondere um eine als separate Einheit funktionsfähige Videokamera mit einer Objektivhalterung handeln, an welche die Lichtaustrittsseite des Kameraobjektivs koppelbar ist. Es kann aber auch ein dezidiertes Gerät mit kalibriertem Auflagemaß vorgesehen sein.

Die genannte Auswerteeinrichtung kann in die Bildaufnahmevorrichtung integriert sein. Die genannte Bildaufnahmevorrichtung muss jedoch nicht zwingend Teil des Diagnosesystems sein. Stattdessen kann der Bildsensor der jeweiligen zu prüfenden Kamera dazu verwendet werden, um gemäß dem von dem Kameraobjektiv erzeugten Abbild des virtuellen Objekts elektrische Bildsignale zu erzeugen, die von der Auswerteeinrichtung hinsichtlich des Fokusgrades ausgewertet werden. In diesem Fall kann die Auswerteeinrichtung insbesondere als separate Einheit oder als in das Objektsimulationsgerät integriertes Elektronikmodul an die jeweilige Kamera anschließbar sein, oder die Auswerteeinrichtung ist als Softwaremodul in die Videokamera integrierbar (durch temporäres oder dauerhaftes Speichern eines Programmcodes in einem Speicher der Videokamera).

In der Auswerteeinrichtung kann die Analyse des Abbildes des virtuellen Objekts durch elektronische Bildanalyse erfolgen. Insbesondere kann die Auswerteeinrichtung dazu angepasst sein, auf der Grundlage der Bildsignale des genannten Bildsensors einen Fokusgrad des Abbildes zu ermitteln.

Das Ermitteln des Fokusgrades kann insbesondere eine Feststellung umfassen, ob oder in welchem Maße sich das virtuelle Objekt im Fokus des Kameraobjektivs befindet. Es kann aber auch ein Ermitteln des Betrags und/oder des Vorzeichens eines Defokus umfassen.

Vorteilhafterweise ist die Auswerteeinrichtung dazu angepasst, die Fokuslage des auf dem Bildsensor erzeugten Abbildes des virtuellen Objekts auf der Grundlage eines Unschärfemusters zu ermitteln. Die Analyse des Unschärfemusters kann beispielsweise auf der Grundlage von Strukturen im Abbild, z.B. einer durch das virtuelle Objekt erzeugten Punktwolke, beispielsweise im Hinblick auf relative Abstände und/oder Absolutpositionen von Strukturmerkmalen erfolgen.

Die Auswerteeinrichtung kann die Fokuslage insbesondere auf der Grundlage einer Größe des Unschärfemusters (z.B. Ausdehnung einer Punktewolke) und/oder auf der Grundlage einer Kantenunschärfe (bzw. Kantenschärfe) des Unschärfemusters (z.B. eines einzelnen Lichtflecks) ermitteln.

Falls an der Lichtquelle des Objektsimulationsgeräts verschiedene Lichtfarben eingestellt werden können, so kann gemäß einer Ausführungsform eine Analyse des erzeugten Abbildes des virtuellen Objekts bzw. eines entsprechenden Sensorbilds dahingehend erfolgen, dass chromatische Aberration unterschiedliche Fokuslagen für das virtuelle Objekt verursacht.

Falls das Objektsimulationsgerät mehrere virtuelle Objekte in unterschiedlichen lateralen Abständen zu der optischen Achse erzeugt, so kann gemäß einer Ausführungsform die Analyse dahingehend erfolgen, dass Bildfeldwölbung unterschiedliche Fokuslagen für die virtuellen Objekte verursacht.

Gemäß einer vorteilhaften Ausführungsform ist die Auswerteeinrichtung dazu angepasst, für verschiedene an dem Kameraobjektiv eingestellte Distanzeinstellwerte einen maximalen Fokusgrad des erzeugten Abbildes des virtuellen Objekts zu ermitteln. Dies kann insbesondere durch iteratives Einstellen verschiedener Distanzeinstellwerte und Ermitteln eines jeweiligen Fokusgrades des Abbildes geschehen, wobei die verschiedenen ermittelten Fokusgrade hinsichtlich eines maximalen Fokusgrades ausgewertet werden (z.B. miteinander verglichen werden). Bei dieser Ausführungsform ist die Auswerteeinrichtung ferner dazu angepasst, auf der Grundlage eines Distanzwerts des virtuellen Objekts, der einer durch das Objektsimulationsgerät (fest oder einstellbar) vorgegebenen Distanz des virtuellen Objekts entspricht, und auf der Grundlage eines an dem Kameraobjektiv eingestellten Distanzeinstellwertes, welcher dem ermittelten maximalen Fokusgrad des Abbildes entspricht, wenigstens einen Korrekturwert zu ermitteln, welcher eine Abweichung zwischen dem Distanzwert des virtuellen Objekts und dem Distanzeinstellwert des Kameraobjektivs (bei maximalem Fokusgrad) repräsentiert. Die Einstellung des Distanzeinstellwertes am Kameraobjektiv kann manuell oder elektromotorisch mittels eines Fokusmechanismus, insbesondere mittels eines Fokuseinstellrings erfolgen, wobei der Distanzeinstellwert einem Wert einer an dem Objektiv dauerhaft angebrachten oder einer elektronisch gespeicherten Entfernungsskala des Objektivs entspricht. Die Auswerteeinrichtung kann insbesondere die Differenz zwischen dem an dem Objektsimulationsgerät eingestellten Distanzwert des virtuellen Objekts und dem am Kameraobjektiv eingestellten Distanzeinstellwert ermitteln, wobei dann der Korrekturwert auf der Grundlage dieser Differenz bestimmt wird.

Der an dem Kameraobjektiv eingestellte Distanzeinstellwert, und optional weitere Werte wie beispielsweise ein eingestellter Blendenwert und/oder eine eingestellte Brennweite, kann bzw. können an die Auswerteeinrichtung sowohl elektronisch von dem Kameraobjektiv bzw. der Kamera übermittelt werden, beispielsweise mit Hilfe eines sogenannten "Lens Data Systems", als auch manuell durch eine Benutzereingabe eines am Kameraobjektiv abgelesenen Einstellwertes. Bei einer elektronischen Übermittlung des jeweiligen Werts ist eine Automatisierung der Korrekturwertermittlung möglich.

Nach einer vorteilhaften Ausführungsform ist die Auswerteeinrichtung dazu angepasst, für verschiedene am Objektsimulationsgerät eingestellte Distanzwerte des virtuellen Objekts (und jeweils korrespondierende, an dem Kameraobjektiv eingestellte Distanzeinstellwerte) einen jeweiligen Korrekturwert zu bestimmen.

Insbesondere kann die Auswerteeinrichtung und/oder eine zusätzliche Steuereinrichtung für ein automatisches Einstellen der Distanz am Objektsimulationsgerät und/oder am Kameraobjektiv angepasst sein.

Gemäß einer weiteren vorteilhaften Ausgestaltung können der oder die Korrekturwerte vom Diagnosesystem dazu verwendet werden, eine Abweichung des Auflagemaßes des Objektivs und/oder der Kamera von einem Nominalwert zu korrigieren. Dies kann beispielsweise durch Einlegen eines die Abweichung kompensierenden Distanzstücks in den kameraseitigen oder objektivseitigen Objektivhalter oder durch eine sonstige Verschiebung der optischen Elemente gegenüber dem Sensor geschehen. Insbesondere kann auf der Grundlage des wenigstens einen Korrekturwerts die Dicke eines die Abweichung kompensierenden Distanzstücks ermittelt werden.

Des Weiteren können der oder die ermittelte(n) Korrekturwert(e) dazu verwendet werden, eine Korrektur einer Entfernungsskala des Kameraobjektivs durchzuführen, wobei auch nichtlineare Abweichungen entlang der Entfernungsskala des Kameraobjektivs berücksichtigt werden können.

Die ermittelten Korrekturwerte können in einem nicht-flüchtigen Speicher beispielsweise in Form einer Lookup-Tabelle gespeichert werden und aus diesem bzw. dieser ausgelesen werden. Ferner können sie zum Erzeugen einer Korrekturfunktion verwendet werden, auf deren Grundlage insbesondere eine automatische Korrektur der Fokuseinstellung des Kameraobjektivs durchgeführt werden kann.

Falls die Fokuseinstellwerte elektronisch im Objektiv-Kamera-System verwaltet werden, können der oder die Korrekturwert(e) oder eine korrigierte Entfernungsskala im Objektiv-Kamera-System gespeichert werden.

Gemäß noch einer weiteren vorteilhaften Ausführungsform ist die Auswerteeinrichtung mit einer Fokusverstellvorrichtung eines elektrisch verstellbaren Kameraobjektivs koppelbar, wobei die Auswerteeinrichtung dazu angepasst ist, auf der Grundlage des oder der ermittelten Korrekturwerte einen Fokuskorrekturwert an die Fokusverstellvorrichtung zu übermitteln. Insbesondere kann der Fokuskorrekturwert in der Fokusverstellvorrichtung gespeichert werden.

Bei einer weiteren vorteilhaften Ausführungsform ist die Auswerteeinrichtung dazu angepasst, den oder die Korrekturwerte ferner in Abhängigkeit von einem an dem Kameraobjektiv eingestellten Blendenwert und/oder in Abhängigkeit von einer an dem Kameraobjektiv eingestellten Brennweite und/oder in Abhängigkeit von einer Gesamtapertur des von der Lichtbündelerzeugungseinrichtung erzeugten, in das Kameraobjektiv eintretenden wenigstens einen Lichtbündels und/oder in Abhängigkeit von einer Farbe des wenigstens einen Lichtbündels, das die Lichtaustrittsfläche des Objektsimulationsgeräts passiert, zu ermitteln. Hierfür können bezüglich desselben Distanzwerts des virtuellen Objekts, der einer durch das Objektsimulationsgerät vorgegebenen Distanz des virtuellen Objekts entspricht, verschiedene Korrekturwerte für unterschiedliche Blendenwerte, unterschiedliche Werte der Brennweite und/oder unterschiedliche Farben ermittelt werden. Hierdurch kann eine Verschiebung der optimalen Fokuslage, die beispielweise auf einer durch sphärische Aberration des Kameraobjektivs bedingten Wölbung der Fokusebene verursacht sein kann, bei der Diagnose und insbesondere auch bei der Korrektur des Kameraobjektivs berücksichtigt werden.

Alternativ zu der Verwendung einer Auswerteeinrichtung kann die Analyse eines Sensorbilds eines Bildsensors einer an das jeweilige Kameraobjektiv angeschlossenen Bildaufnahmeeinrichtung auch visuell, beispielsweise anhand der Wiedergabe auf einem Monitor, erfolgen.

Insofern ist die genannte Auswerteeinrichtung nicht zwingender Bestandteil des Diagnosesystems, und die vorliegende Erfindung bezieht sich auch auf ein Diagnosesystem mit einem Objektsimulationsgerät nach einer der vorstehend erläuterten Ausführungsformen und mit einer Bildaufnahmevorrichtung, wobei die Bildaufnahmevorrichtung eine Kopplungseinrichtung aufweist, die dazu angepasst ist, eine Lichteintrittsseite der Bildaufnahmevorrichtung an eine Lichtaustrittsseite des jeweiligen Kameraobjektivs zu koppeln, wobei die Bildaufnahmevorrichtung ferner einen Bildsensor zum Erzeugen elektrischer Bildsignale auf der Grundlage eines von dem jeweiligen Kameraobjektiv auf dem Bildsensor erzeugten Abbildes des virtuellen Objekts aufweist.

Weitere vorteilhafte Ausführungsformen der Erfindung sind in den Unteransprüchen, der Beschreibung und den Zeichnungen genannt.

Die Erfindung wird nachfolgend anhand von Ausführungsbeispielen beschrieben. Es zeigen:
- Fig. 1: eine schematische Darstellung eines Diagnosesystems geräts gemäß einem ersten Ausführungsbeispiel mit einem einzigen virtuellen Objekt;
- Fig. 2: eine schematische Darstellung eines Diagnosesystems geräts gemäß einem zweiten Ausführungsbeispiel mit mehreren virtuellen Objekten;
- Fig. 3: eine schematische Darstellung eines Objektsimulationsgeräts gemäß einem Ausführungsbeispiel mit mehreren laserähnlichen beweglichen Lichtquellen, die schmale Lichtbündel erzeugen;
- Fig. 4: eine schematische Darstellung eines Objektsimulationsgeräts gemäß einem weiteren Ausführungsbeispiel mit mehreren Linsen zur Abbildung einer jeweiligen Lichtquelle auf das virtuelle Objekt;
- Fig. 5: mehrere Abbilder eines virtuellen Objekts, die für unterschiedliche Distanzeinstellwerte erzeugt werden, in Form einer jeweiligen Punktwolke; und
- Fig. 6: mehrere Abbilder eines virtuellen Objekts, die für unterschiedliche Distanzeinstellwerte erzeugt werden, in Form von unterschiedlich aufgeweiteten Lichtflecken.

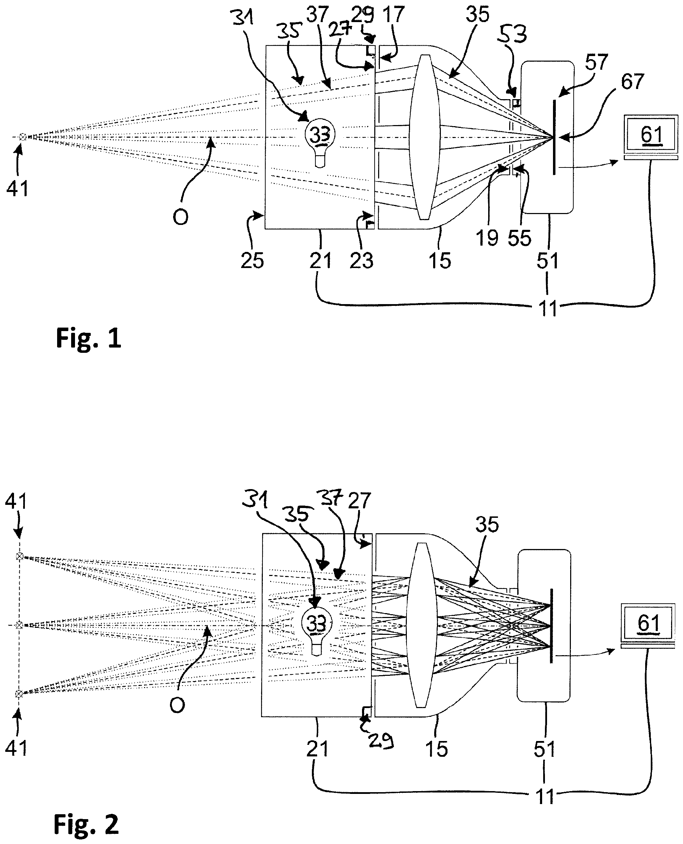

Fig. 1 zeigt in schematischer Darstellung den Grundaufbau eines Diagnosesystems 11 gemäß einem ersten Ausführungsbeispiel mit einem einzigen virtuellen Objekt. Das Diagnosesystem 11 dient zum Prüfen eines Kameraobjektivs 15 und umfasst ein Objektsimulationsgerät 21. Dem Objektsimulationsgerät 21 ist eine Bildaufnahmevorrichtung 51 zugeordnet, die Teil des Diagnosesystems 11 und ein speziell angepasstes Gerät sein kann. Die Bildaufnahmevorrichtung 51 kann allerdings auch durch eine als separate Einheit funktionsfähige Videokamera gebildet sein, insbesondere durch eine handelsübliche Videokamera mit Wechselobjektivhalterung. Das Diagnosesystem 11 kann auch zum Prüfen eines Systems aus Kameraobjektiv 15 und Kamera dienen, wobei in diesem Falle die Bildaufnahmevorrichtung 51 durch die zu prüfende Kamera gebildet ist.

Das Objektsimulationsgerät 21 weist bezüglich einer optischen Achse O eine Vorderseite 23 und eine Rückseite 25 auf. An der Vorderseite 23 des Objektsimulationsgeräts 21 sind eine Lichtaustrittsfläche 27 und eine Kopplungseinrichtung 29 (schematisch dargestellt) vorgesehen, mittels derer die Vorderseite 23 des Objektsimulationsgeräts 21 an eine Lichteintrittsseite 17 des Kameraobjektivs 15 gekoppelt ist. Das Objektsimulationsgerät 21 weist ferner eine Lichtbündelerzeugungseinrichtung 31 auf (symbolisch durch eine Lichtquelle 33 dargestellt), die wenigstens ein Lichtbündel 35 erzeugt. Generell kann es sich hierbei um ein einziges (insbesondere divergentes bzw. kegelförmiges) Lichtbündel 35 handeln, oder die Lichtbündelerzeugungseinrichtung 31 erzeugt mehrere (insbesondere ineinander übergehende oder voneinander separate) Lichtbündel 35, welche die Lichtaustrittsfläche 27 in Richtung der Lichteintrittsseite 17 des Kameraobjektivs 15 passieren. Das Lichtbündel 35 oder die mehreren Lichtbündel 35 passiert/passieren die Lichtaustrittsfläche 27 des Objektsimulationsgeräts 21 in unterschiedlichem lateralen Abstand zu der optischen Achse O und entlang einer jeweiligen Lichtaustrittsachse 37.

Die Lichtaustrittsachsen 37 sind derart ausgerichtet, dass das bzw. die Lichtbündel 35 von demselben Punkt auf der optischen Achse O auszugehen scheinen. Dieser Punkt bildet somit ein virtuelles Objekt 41, und die Lichtaustrittsachsen 37 sind derart angeordnet und ausgerichtet, dass das bzw. die Lichtbündel 35 scheinbar von einem einzigen virtuellen Objekt 41 ausgeht/ausgehen. Das virtuelle Objekt 41 befindet sich in einer Distanz zu der Lichtaustrittsfläche 27 des Objektsimulationsgeräts 21, die größer ist als die Distanz zwischen der Lichtbündelerzeugungseinrichtung 31 und der Lichtaustrittsfläche 27. Das virtuelle Objekt 41 befindet sich hierbei außerhalb des Objektsimulationsgeräts 21, nämlich jenseits der Rückseite 25.

Das bzw. die Lichtbündel 35 kann/können bezüglich der optischen Achse O in Umfangsrichtung derart verteilt angeordnet sein, dass das bzw. die Lichtbündel 35 die Lichtaustrittsfläche 27 des Objektsimulationsgeräts 21 an Austrittsstellen passiert/passieren, die zumindest im Wesentlichen über die gesamte Lichtaustrittsfläche 27 verteilt sind. Hierdurch können die Lichtbündel 35 die Eintrittspupille an der Lichteintrittsseite 17 des Kameraobjektivs 15 zumindest im Wesentlichen vollständig ausfüllen. Alternativ hierzu ist es jedoch auch möglich - und grundsätzlich ausreichend -, dass die Austrittsstellen des bzw. der Lichtbündel(s) 35 lediglich einen Teilbereich der Lichtaustrittsfläche 27 des Objektsimulationsgeräts 21 belegen. Insofern ist Fig. 1 so zu verstehen, dass die darin eingezeichneten Linien lediglich mehrere mögliche Lichtwege darstellen, die jedoch nicht alle von der Lichtbündelerzeugungseinrichtung 31 beleuchtet werden müssen.

Die Bildaufnahmevorrichtung 51 weist eine Kopplungseinrichtung 53 auf (schematisch dargestellt), mittels derer eine Lichteintrittsseite 55 der Bildaufnahmevorrichtung 51 an eine Lichtaustrittsseite 19 des Kameraobjektivs 15 gekoppelt ist. Die Bildaufnahmevorrichtung 51 weist ferner einen Bildsensor 57 auf. Der Bildsensor 57 umfasst eine zweidimensionale Anordnung von lichtempfindlichen Empfangselementen und erzeugt elektrische Bildsignale auf der Grundlage eines von dem Kameraobjektiv 15 auf dem Bildsensor 57 erzeugten Abbildes des virtuellen Objekts 41. Mit dem Bildsensor 57 ist eine Auswerteeinrichtung 61 (symbolisch dargestellt) verbunden, die auch in die Bildaufnahmevorrichtung 51 integriert sein kann. Die Auswerteeinrichtung 61 kann auf der Grundlage der Bildsignale des Bildsensors 57 einen Fokusgrad des Abbildes des virtuellen Objekts 41 ermitteln. Dies kann insbesondere auf der Grundlage eines Unschärfemusters des Abbildes geschehen, wie nachfolgend noch erläutert wird.

Die Bildaufnahmevorrichtung 51 kann, wie bereits erwähnt, eine als separate Einheit funktionsfähige Videokamera sein. Sofern die Bildaufnahmevorrichtung 51 nicht fester Bestandteil des Diagnosesystems 11 ist, sondern beispielsweise eine handelsübliche Videokamera, insbesondere eine zu prüfende Videokamera, so umfasst das Diagnosesystem 11 vorzugsweise zumindest die Auswerteeinrichtung 61, die z.B. als Elektronikmodul an die Videokamera anschließbar ist oder z.B. als Softwaremodul in die Videokamera integrierbar ist (durch temporäres oder dauerhaftes Speichern eines Programmcodes in einem Speicher der Videokamera).

Das Kameraobjektiv 25 weist einen mit einer Entfernungsskala versehenen Fokusmechanismus auf (nicht gezeigt). Mittels des Fokusmechanismus können verschiedene Distanzeinstellwerte eingestellt werden, um eine Bildschärfe des mittels des Kameraobjektivs 25 erzeugten Abbildes anzupassen.

Mittels der Auswerteeinrichtung 61 kann ein Korrekturwert ermittelt werden, der eine Abweichung zwischen der Distanz des virtuellen Objekts 41 von dem Bildsensor 57 einerseits und der am Kameraobjektiv 15 eingestellten Distanz gemäß der Entfernungsskala andererseits repräsentiert. Der Distanzwert des virtuellen Objekts 41 kann durch vorherige Kalibrierung des Objektsimulationsgeräts 21, oder des Systems aus Objektsimulationsgerät 21 und Bildaufnahmevorrichtung 51, mit hoher Genauigkeit bekannt sein. Somit kann der ermittelte Korrekturwert dazu dienen, ein nominales (beispielsweise bei der Herstellung des Kameraobjektivs 15 ermitteltes) Auflagemaß zu korrigieren. Insbesondere kann der ermittelte Korrekturwert dazu dienen, eine Korrektur der Entfernungsskala des Kameraobjektivs 15 durchzuführen.

Das Ermitteln des Korrekturwerts mittels der Auswerteeinrichtung 61 kann beispielsweise dadurch erfolgen, dass für verschiedene an dem Kameraobjektiv 15 eingestellte Distanzeinstellwerte ein maximaler Fokusgrad des auf dem Bildsensor 57 erzeugten jeweiligen Abbildes des virtuellen Objekts 41 ermittelt wird. Durch gegenseitigen Vergleich der ermittelten Fokusgrade kann festgestellt werden, für welchen an dem Kameraobjektiv 15 eingestellten Distanzeinstellwert die höchste Bildschärfe erreicht wird. Für diesen Distanzeinstellwert ist aufgrund des Objektsimulationsgeräts 21 der entsprechende Distanzwert des virtuellen Objekts 41 genau bekannt. Aus einer Abweichung zwischen diesen beiden Distanzwerten kann sodann (beispielsweise auf Grundlage einer Differenzbildung) der gesuchte Korrekturwert bestimmt werden.

Ein Vorteil des Objektsimulationsgeräts 21 besteht darin, dass das virtuelle Objekt 41 sich außerhalb des Objektsimulationsgeräts 21 befinden kann. Somit kann das Objektsimulationsgerät 21 dazu verwendet werden, auch relativ große Distanzeinstellwerte des Kameraobjektivs 15 auf deren Genauigkeit zu prüfen. Gleichwohl kann das Objektsimulationsgerät 21 entlang der optischen Achse O sehr kompakt gebaut sein.

Zu Fig. 1 ist auch noch anzumerken, dass die Lichtbündelerzeugungseinrichtung 31 auch derart verstellbar sein kann, dass das virtuelle Objekt 41 zeitlich nacheinander an verschiedenen Punkten entlang der optischen Achse O erzeugt wird. Hierdurch kann das Kameraobjektiv 25 bzw. das System aus Kameraobjektiv 25 und Bildaufnahmevorrichtung 51 bzw. Videokamera über einen Bereich von mehreren Distanzeinstellwerten überprüft werden, und es können verschiedene Korrekturwerte für unterschiedliche Distanzeinstellwerte des Kameraobjektivs 15 ermittelt werden.

Das in Fig. 2 gezeigte Ausführungsbeispiel illustriert gegenüber Fig. 1, dass mittels der Lichtbündelerzeugungseinrichtung 31 auch mehrere virtuelle Objekte 41 erzeugt werden können, die innerhalb derselben Orthogonalebene zu der optischen Achse O in unterschiedlichem lateralen Abstand zu der optischen Achse O, also in unterschiedlicher Bildhöhe, angeordnet sind. Hierfür können die Lichtaustrittsachsen 37 der Lichtbündel 35 an der Lichtaustrittsfläche 27 des Objektsimulationsgeräts 21 entsprechend den verschiedenen virtuellen Objekten 41 unterschiedlich ausgerichtet sein. Die mehreren virtuellen Objekte 41 können insbesondere gleichzeitig erzeugt werden.

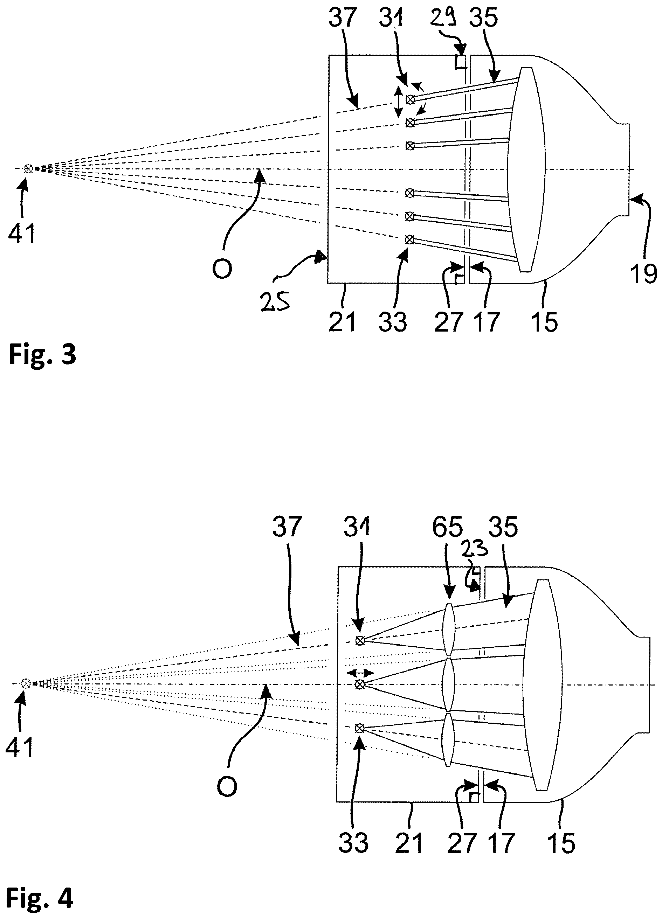

Nachfolgend werden anhand der Fig. 3 und 4 zwei mögliche Ausführungsbeispiele für eine Lichtbündelerzeugungseinrichtung 31 des Objektsimulationsgeräts 21 erläutert, die erfindungsgemäß mehrere Lichtquellen 33 aufweist.

Gemäß Fig. 3 umfasst die Lichtbündelerzeugungseinrichtung 31 mehrere Lichtquellen 33 (z.B. Leuchtdioden oder Laserdioden), von denen jede ein schmales Lichtbündel 35 entlang einer Lichtaustrittsachse 37 emittiert. Das jeweilige Lichtbündel 35 kann parallel sein oder im Wesentlichen einen einzigen Lichtstrahl umfassen. Den Lichtquellen 33 kann ein jeweiliges optisches Abbildungselement zugeordnet sein (in Fig. 3 nicht gezeigt). Die Lichtquellen 33 sind innerhalb derselben Orthogonalebene zu der optischen Achse O) und in unterschiedlichem lateralen Abstand zu der optischen Achse O angeordnet.

Wie in Fig. 3 für die oberste Lichtquelle 33 durch einen jeweiligen Doppelpfeil angedeutet ist, können der jeweilige Abstand der Lichtquellen 33 zu der optischen Achse O und die jeweilige Ausrichtung der Lichtquellen 33 bzw. der emittierten Lichtbündel 35 verstellt werden. Hierdurch kann die Distanz zwischen dem virtuellen Objekt 41 und der Lichtaustrittsfläche 27 des Objektsimulationsgeräts 21 verändert werden. Insbesondere kann allein durch Verstellen der jeweiligen Ausrichtung der Lichtquellen 33 der Austrittswinkel des jeweiligen Lichtbündels 35 variiert werden, mit dem das Lichtbündel 35 die Lichtaustrittsfläche 27 des Objektsimulationsgeräts 21 passiert. Gemeinsam mit der jeweiligen Lichtquelle 33 kann ein zugeordnetes Abbildungselement verstellt werden. Für das Verstellen der jeweiligen Lichtquelle 33 kann eine elektrische ansteuerbare Antriebseinrichtung vorgesehen sein (nicht dargestellt).

Gemäß Fig. 4 umfasst die Lichtbündelerzeugungseinrichtung 31 mehrere Lichtquellen 33 (z.B. Leuchtdioden oder Laserdioden), von denen jede ein divergentes Lichtbündel 35 entlang einer Lichtaustrittsachse 37 emittiert. Die Lichtbündelerzeugungseinrichtung 31 umfasst mehrere optische Abbildungselemente 65 in Form von Linsen, wobei jeder Lichtquelle 33 ein jeweiliges Abbildungselement 65 zugeordnet ist. Fig. 4 illustriert somit die jeweilige Abbildung mehrerer Lichtquellen 33 auf ein virtuelles Objekt 41 durch optische Elemente 65, wobei mehrere Lichtquellen 33 auf das gleiche virtuelle Objekt 41 abgebildet werden.

Wie in Fig. 4 für die mittlere Lichtquelle 33 durch einen Doppelpfeil angedeutet ist, kann die Position der jeweiligen Lichtquelle 33 relativ zu dem jeweiligen Abbildungselement 65 verstellt werden, um die Distanz zwischen dem virtuellen Objekt 41 und der Lichtaustrittsfläche 27 des Objektsimulationsgeräts 21 zu verändern. Die Verstellbarkeit der Position der jeweiligen Lichtquelle 33 kann beispielsweise entlang der optischen Achse O erfolgen.

Was schließlich die Auswertung des auf dem Bildsensor 57 erzeugten Abbildes des jeweiligen virtuellen Objekts 41 betrifft, so hängt der Fokusgrad von dem kombinierten Auflagemaß von Kameraobjektiv 15 und Bildaufnahmevorrichtung 51, dem Distanzwert des virtuellen Objekts 41 und dem Distanzeinstellwert des Kameraobjektivs 15 ab.

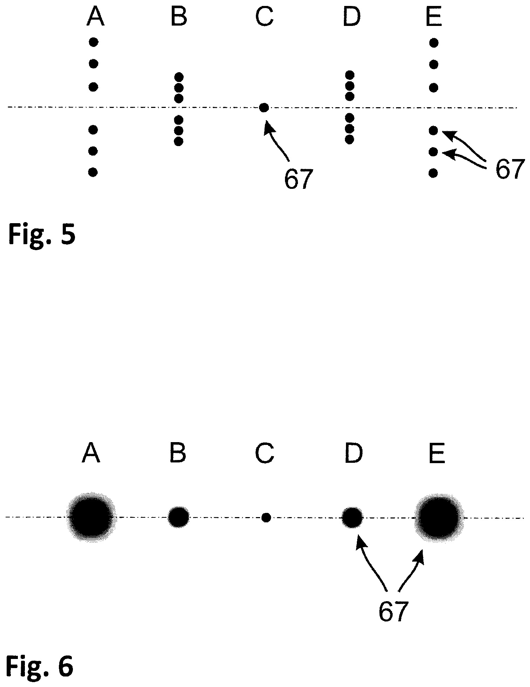

Am Bildsensor 57 werden beispielsweise einzelne Abbilder des virtuellen Objekts in verschiedenen Höhen über der optischen Achse erzeugt, die bei korrekter Einstellung von Distanzeinstellwert und Auflagemaß zumindest im Wesentlichen zu einem einzigen Bild zusammenlaufen. Derartige verschiedene Abbilder des virtuellen Objekts für unterschiedliche Distanzeinstellwerte des Kameraobjektivs 15 sind beispielhaft in Fig. 5 gezeigt (unterschiedliche Distanzeinstellwerte von links nach rechts gezeigt). Fig. 5 illustriert für unterschiedliche Distanzeinstellwerte A, B, C, D und E des Kameraobjektivs 15 die Ermittlung des Fokusgrades anhand der Größe einer auf der lichtempfindlichen Fläche des Bildsensors 57 erzeugten Punktwolke (mehrere voneinander unterscheidbare Lichtflecken 67). Das virtuelle Objekt 41 muss hierfür zumindest annähernd einer Punktlichtquelle entsprechen, so dass die vom virtuellen Objekt 41 (scheinbar) ausgehenden Lichtbündel 35 die einzelnen (nahezu punktförmigen) Lichtflecken 67 gemäß Fig. 5 erzeugen. Bei geringem Fokusgrad können die einzelnen Lichtbündel 35 bzw. die hiervon auf dem Bildsensor 57 erzeugten Lichtflecken 67 voneinander unterschieden werden. Es ist ersichtlich, dass der Distanzeinstellwert C des Kameraobjektivs 15, für den das mittlere Abbild erzeugt wird, einem maximalen Fokusgrad entspricht.

Die Auswerteeinrichtung 61 kann den Fokusgrad des Abbildes des jeweiligen virtuellen Objekts 41 auf dem Bildsensor 57 auch auf der Grundlage eines Unschärfemusters eines einzelnen Lichtflecks 67 ermitteln. Fig. 6 illustriert die Ermittlung des Fokusgrads anhand der Kantenschärfe eines derartigen auf der lichtempfindlichen Fläche des Bildsensors 57 erzeugten Lichtflecks 67. Das virtuelle Objekt 41 muss dabei eine kleine flächige Ausdehnung haben. Fig. 6 zeigt eine Gegenüberstellung des jeweiligen Abbildes eines virtuellen Objekts 41 für unterschiedliche Distanzeinstellwerte A, B, C, D und E des Kameraobjektivs 15 (wiederum von links nach rechts gezeigt). Die Abbilder erscheinen als jeweiliger Lichtfleck 67. Der Distanzeinstellwert C, für den das mittlere Abbild erzeugt wird, entspricht einer maximalen Kantenschärfe des durch das Abbild gebildeten Unschärfemusters und somit einem maximalen Fokusgrad.

### Bezugszeichenliste

- 11: Diagnosesystem
- 15: Kameraobjektiv
- 17: Lichteintrittsseite des Kameraobjektivs
- 19: Lichtaustrittsseite des Kameraobjektivs
- 21: Objektsimulationsgerät
- 23: Vorderseite des Objektsimulationsgeräts
- 25: Rückseite des Objektsimulationsgeräts
- 27: Lichtaustrittsfläche des Objektsimulationsgeräts
- 29: Kopplungseinrichtung des Objektsimulationsgeräts
- 31: Lichtbündelerzeugungseinrichtung
- 33: Lichtquelle
- 35: Lichtbündel
- 37: Lichtaustrittsachse
- 41: virtuelles Objekt
- 51: Bildaufnahmevorrichtung
- 53: Kopplungseinrichtung der Bildaufnahmevorrichtung
- 55: Lichteintrittsseite der Bildaufnahmevorrichtung
- 57: Bildsensor
- 61: Auswerteeinrichtung
- 65: Abbildungselement
- 67: Lichtfleck
- O: optische Achse

## Patentansprüche

1. Objektsimulationsgerät (21) zum Prüfen eines Kameraobjektivs (15), wobei das Objektsimulationsgerät (21) eine optische Achse (O) und an einem Ende bezüglich der optischen Achse (O) eine Vorderseite (23) aufweist, mit:
einer Lichtaustrittsfläche (27) an der Vorderseite (23) des Objektsimulationsgeräts (21);
einer Kopplungseinrichtung (29), die dazu angepasst ist, die Vorderseite (23) des Objektsimulationsgeräts (21) an eine Lichteintrittsseite eines jeweiligen Kameraobjektivs (15) zu koppeln; und
einer Lichtbündelerzeugungseinrichtung (31), die wenigstens eine Lichtquelle (33) aufweist und die dazu angepasst ist, wenigstens ein Lichtbündel (35) zu erzeugen, das die Lichtaustrittsfläche (27) derart passiert, dass das wenigstens eine Lichtbündel (35) scheinbar von wenigstens einem virtuellen Objekt (41) ausgeht, welches sich in einer Distanz zu der Lichtaustrittsfläche (27) befindet, die größer ist als die Distanz zwischen der Lichtbündelerzeugungseinrichtung (31) und der Lichtaustrittsfläche (27),
**dadurch gekennzeichnet,**
**dass** die Lichtbündelerzeugungseinrichtung (31) mehrere Lichtquellen (33) aufweist, wobei:
- die Position und/oder die Ausrichtung der mehreren Lichtquellen (33) derart verstellbar ist, dass durch ein Verstellen der mehreren Lichtquellen (33) die Distanz zwischen dem virtuellen Objekt (41) und der Lichtaustrittsfläche (27) des Objektsimulationsgeräts (21) veränderbar ist; und/oder
- die Lichtbündelerzeugungseinrichtung (31) ferner mehrere Abbildungselemente (65) aufweist, wobei jeder der mehreren Lichtquellen (33) wenigstens eines der mehreren Abbildungselemente (65) zugeordnet ist, wobei die Position und/oder die Ausrichtung der mehreren Abbildungselemente (65) derart verstellbar ist, dass durch ein Verstellen der mehreren Abbildungselemente die Distanz zwischen dem virtuellen Objekt (41) und der Lichtaustrittsfläche (27) des Objektsimulationsgeräts (21) veränderbar ist.

2. Objektsimulationsgerät (21) nach Anspruch 1,
wobei das virtuelle Objekt (41) zumindest im Wesentlichen einer virtuellen Punktlichtquelle entspricht; oder
wobei das virtuelle Objekt (41) einer linienförmigen virtuellen Lichtquelle entspricht, die sich innerhalb einer Orthogonalebene zu der optischen Achse (O) erstreckt; oder
wobei das virtuelle Objekt (41) einer zweidimensionalen virtuellen Lichtquelle entspricht, die sich innerhalb einer Orthogonalebene zu der optischen Achse (O) erstreckt.

3. Objektsimulationsgerät (21) nach Anspruch 1 oder 2,
wobei die Lichtbündelerzeugungseinrichtung (31) dazu angepasst ist, zeitlich nacheinander ein jeweiliges virtuelles Objekt (41) auf der optischen Achse (O) in verschiedenen Distanzen zu der Lichtaustrittsachse (37) des Objektsimulationsgeräts (21) zu erzeugen; und/oder wobei die Lichtbündelerzeugungseinrichtung (31) dazu angepasst ist, gleichzeitig mehrere virtuelle Objekte (41) innerhalb einer Orthogonalebene zu der optischen Achse (O) zu erzeugen; und/oder wobei die Lichtbündelerzeugungseinrichtung (31) dazu angepasst ist, gleichzeitig mehrere virtuelle Objekte (41) in unterschiedlichem lateralen Abstand zu der optischen Achse (O) zu erzeugen.

4. Objektsimulationsgerät (21) nach einem der vorhergehenden Ansprüche,
wobei das wenigstens eine Lichtbündel (35) die Lichtaustrittsfläche (27) des Objektsimulationsgeräts (21) entlang einer Lichtaustrittsachse (37) passiert, die bezüglich der optischen Achse (O) des Objektsimulationsgeräts (21) um einen Austrittswinkel geneigt ist, wobei der Austrittswinkel einstellbar ist; und/oder
wobei der laterale Abstand des wenigstens einen virtuellen Objekts (41) zu der optischen Achse (O) des Objektsimulationsgeräts (21) einstellbar ist.

5. Objektsimulationsgerät (21) nach einem der vorhergehenden Ansprüche,
wobei die Lichtbündelerzeugungseinrichtung (31) dazu angepasst ist, mehrere Lichtbündel (35) zu erzeugen, welche die Lichtaustrittsfläche (27) passieren.

6. Objektsimulationsgerät (21) nach Anspruch 5,
wobei die mehreren Lichtbündel (35) die Lichtaustrittsfläche (27) des Objektsimulationsgeräts (21) entlang einer jeweiligen Lichtaustrittsachse (37) passieren, wobei die Lichtaustrittsachsen (37) derart ausgerichtet sind, dass die mehreren Lichtbündel (35) von dem wenigstens einen virtuellen Objekt (41) auszugehen scheinen; und/oder
wobei zumindest einige der mehreren Lichtbündel (35) bezüglich der optischen Achse (O) in Umfangsrichtung verteilt angeordnet sind; und/oder wobei zumindest einige der mehreren Lichtbündel (35) die Lichtaustrittsfläche (27) in unterschiedlichem Abstand zu der optischen Achse (O) passieren; und/oder
wobei die mehreren Lichtbündel (35) separat voneinander sind; und/oder wobei die Lichtbündelerzeugungseinrichtung (31) dazu angepasst ist, die mehreren Lichtbündel (35) derart zu erzeugen, dass die mehreren Lichtbündel (35) die Lichtaustrittsfläche (27) des Objektsimulationsgeräts (21) an Austrittsstellen passieren, die voneinander beabstandet sind, um eine Eintrittspupille des jeweiligen Kameraobjektivs (15) lediglich teilweise auszufüllen, oder die zumindest im Wesentlichen über die gesamte Lichtaustrittsfläche (27) verteilt sind, um eine Eintrittspupille des jeweiligen Kameraobjektivs (15) zumindest im Wesentlichen vollständig auszufüllen.

7. Objektsimulationsgerät (21) nach Anspruch 5 oder 6,
wobei jede der mehreren Lichtquellen (33) wenigstens eines der mehreren Lichtbündel (35) erzeugt und/oder jede der mehreren Lichtquellen (33) ein einziges der mehreren Lichtbündel (35) erzeugt.

8. Objektsimulationsgerät (21) nach einem der vorhergehenden Ansprüche,
wobei die mehreren Lichtquellen (33) innerhalb derselben Orthogonalebene zu der optischen Achse (O) angeordnet sind; und/oder wobei zumindest einige der mehreren Lichtquellen (33) bezüglich der optischen Achse (O) in Umfangsrichtung verteilt angeordnet sind.

9. Objektsimulationsgerät (21) nach einem der vorhergehenden Ansprüche,
wobei zumindest einige der mehreren Lichtquellen (33) in unterschiedlichem Abstand zu der optischen Achse (O) angeordnet sind.

10. Objektsimulationsgerät (21) nach einem der vorhergehenden Ansprüche,
wobei das wenigstens eine virtuelle Objekt (41) außerhalb des Objektsimulationsgeräts (21) liegt; und/oder
wobei die Lichtbündelerzeugungseinrichtung (31) wenigstens eine Blendenvorrichtung umfasst, wobei die Blendenvorrichtung wenigstens eine bezüglich ihrer Öffnungsweite und/oder Position variable Blendenöffnung aufweist, welche Teile des von der wenigstens einen Lichtquelle (33) emittierten Lichts durchlässt; und/oder
wobei die wenigstens eine Lichtquelle (33) weißes Licht emittiert; und/oder
wobei die Lichtbündelerzeugungseinrichtung (31) dazu angepasst ist, das wenigstens eine Lichtbündel (35) mit einer von mehreren verschiedenen auswählbaren Farben zu erzeugen.

11. Diagnosesystem (11) mit einem Objektsimulationsgerät (21) nach einem der vorhergehenden Ansprüche, mit einer Auswerteeinrichtung (61), die dazu angepasst ist, einen Fokusgrad eines Abbildes des wenigstens einen virtuellen Objekts (41) zu ermitteln, welches Abbild von dem an das Objektsimulationsgerät (21) gekoppelten jeweiligen Kameraobjektiv (15) erzeugt wird.

12. Diagnosesystem (11) nach Anspruch 11,
wobei das Diagnosesystem (11) ferner eine Bildaufnahmevorrichtung (51) umfasst, wobei die Bildaufnahmevorrichtung (51) eine Kopplungseinrichtung (53) aufweist, die dazu angepasst ist, eine Lichteintrittsseite (55) der Bildaufnahmevorrichtung (51) an eine Lichtaustrittsseite (19) des jeweiligen Kameraobjektivs (15) zu koppeln, und wobei die Bildaufnahmevorrichtung (51) einen Bildsensor (57) zum Erzeugen elektrischer Bildsignale auf der Grundlage eines von dem jeweiligen Kameraobjektiv (15) auf dem Bildsensor (57) erzeugten Abbildes des virtuellen Objekts (41) aufweist, wobei die Auswerteeinrichtung (61) direkt oder indirekt mit dem Bildsensor (57) verbunden oder verbindbar ist;
wobei die Bildaufnahmevorrichtung (51) vorzugsweise eine Videokamera mit einer Objektivhalterung ist, an welche die Lichtaustrittsseite (19) des Kameraobjektivs (15) koppelbar ist.

13. Diagnosesystem (11) nach Anspruch 11 oder 12,
wobei die Auswerteeinrichtung (61) dazu angepasst ist, den Fokusgrad des Abbildes des virtuellen Objekts (41) auf der Grundlage eines Unschärfemusters zu ermitteln;
wobei vorzugsweise die Auswerteeinrichtung (61) dazu angepasst ist, den Fokusgrad auf der Grundlage einer Größe des Unschärfemusters und/oder auf der Grundlage einer Kantenunschärfe des Unschärfemusters zu ermitteln; und/oder das Abbild des wenigstens einen virtuellen Objekts (41) einen oder mehrere Lichtflecken (67) umfasst.

14. Diagnosesystem (11) nach einem der Ansprüche 11 bis 13,
wobei die Auswerteeinrichtung (61) dazu angepasst ist, für verschiedene an dem Kameraobjektiv (15) eingestellte Distanzeinstellwerte einen maximalen Fokusgrad des Abbildes des virtuellen Objekts (41) zu ermitteln; und
wobei die Auswerteeinrichtung (61) ferner dazu angepasst ist, auf der Grundlage eines Distanzwerts des virtuellen Objekts (41), der einer durch das Objektsimulationsgerät (21) vorgegebenen Distanz des virtuellen Objekts (41) entspricht, und auf der Grundlage eines an dem Kameraobjektiv (15) eingestellten Distanzeinstellwertes, welcher dem ermittelten maximalen Fokusgrad des Abbildes entspricht, wenigstens einen Korrekturwert zu ermitteln, welcher eine Abweichung zwischen dem Distanzwert des virtuellen Objekts (41) und dem Distanzeinstellwert des Kameraobjektivs (15) repräsentiert;
wobei die Auswerteeinrichtung (61) vorzugsweise dazu angepasst ist, für verschiedene am Objektsimulationsgerät (21) eingestellte Distanzwerte des virtuellen Objekts (41) einen jeweiligen Korrekturwert zu ermitteln und/oder auf der Grundlage des ermittelten Korrekturwerts die Dicke eines die Abweichung kompensierenden Distanzstücks zu ermitteln, welches zum Einlegen zwischen dem jeweiligen Kameraobjektiv (15) und einer Kamera, zwischen dem jeweiligen Kameraobjektiv (15) und einem mit einer Kamera verbindbaren Objektivhalter, oder zwischen einem mit einer Kamera verbindbaren Objektivhalter und der Kamera vorgesehen ist.

15. Diagnosesystem (11) nach Anspruch 14,
wobei die Auswerteeinrichtung (61) mit einer Fokusverstellvorrichtung eines elektrisch verstellbaren Kameraobjektivs (15) koppelbar ist, und wobei die Auswerteeinrichtung (61) dazu angepasst ist, auf der Grundlage des oder der ermittelten Korrekturwerte einen Fokuskorrekturwert an die Fokusverstellvorrichtung zu übermitteln; und/oder
wobei die Auswerteeinrichtung (61) dazu angepasst ist, den oder die Korrekturwerte ferner in Abhängigkeit von
- einem an dem Kameraobjektiv (15) eingestellten Blendenwert, und/oder
- einer Brennweite des Kameraobjektivs (15), und/oder
- einer Gesamtapertur des von der Lichtbündelerzeugungseinrichtung (31) erzeugten, in das Kameraobjektiv (15) eintretenden wenigstens einen Lichtbündels (35), und/oder
- einer Farbe des wenigstens einen Lichtbündels (35) zu ermitteln.

## Claims

1. An object simulation unit (21) for testing a camera objective (15), wherein the object simulation unit (21) has an optical axis (O) and a front side (23) with respect to the optical axis (O) at one end, comprising:
a light exit surface (27) at the front side (23) of the object simulation unit (21);
a coupling device (29) which is adapted to couple the front side (23) of the object simulation unit (21) to a light entry side of a respective camera objective (15); and
a light beam generation device (31) which has at least one light source (33) and which is adapted to generate at least one light beam (35) which passes through the light exit surface (27) such that the at least one light beam (35) apparently starts from at least one virtual object (41) which is located at a distance from the light exit surface (27) that is larger than the distance between the light beam generation device (31) and the light exit surface (27),
**characterized in that**
the light beam generation device (31) has a plurality of light sources (33),
wherein:
- the position and/or the orientation of the plurality of light sources (33) is/are adjustable such that the distance between the virtual object (41) and the light exit surface (27) of the object simulation unit (21) is variable by an adjustment of the plurality of light sources (33); and/or
- the light beam generation device (31) furthermore has a plurality of imaging elements (65), with at least one of the plurality of imaging elements (65) being associated with each of the plurality of light sources (33), and with the position and/or the orientation of the plurality of imaging elements (65) being adjustable such that the distance between the virtual object (41) and the light exit surface (27) of the object simulation unit (21) is variable by an adjustment of the plurality of imaging elements.

2. An object simulation unit (21) in accordance with claim 1,
wherein the virtual object (41) at least substantially corresponds to a virtual point light source; or
wherein the virtual object (41) corresponds to a linear virtual light source which extends within an orthogonal plane with respect to the optical axis (O); or
wherein the virtual object (41) corresponds to a two-dimensional virtual light source which extends within an orthogonal plane with respect to the optical axis (O).

3. An object simulation unit (21) in accordance with claim 1 or claim 2,
wherein the light beam generation device (31) is adapted to generate a respective virtual object (41) on the optical axis (O) after one another in time at different distances from the light exit axis (37) of the object simulation unit (21); and/or
wherein the light beam generation device (31) is adapted to simultaneously generate a plurality of virtual objects (41) within an orthogonal plane with respect to the optical axis (O); and/or
wherein the light beam generation device (31) is adapted to simultaneously generate a plurality of virtual objects (41) at different lateral spacings from the optical axis (O).

4. An object simulation unit (21) in accordance with any one of the preceding claims,
wherein the at least one light beam (35) passes through the light exit surface (27) of the object simulation unit (21) along a light exit axis (37) which is inclined by an exit angle with respect to the optical axis (O) of the object simulation unit (21), with the exit angle being settable; and/or
wherein the lateral spacing of the at least one virtual object (41) from the optical axis (O) of the object simulation unit (21) is settable.

5. An object simulation unit (21) in accordance with any one of the preceding claims,
wherein the light beam generation device (31) is adapted to generate a plurality of light beams (35) which pass through the light exit surface (27).

6. An object simulation unit (21) in accordance with claim 5,
wherein the plurality of light beams (35) pass through the light exit surface (27) of the object simulation unit (21) along a respective light exit axis (37), with the light exit axes (37) being oriented such that the plurality of light beams (35) appear to start from the at least one virtual object (41); and/or
wherein at least some of the plurality of light beams (35) are arranged distributed in the peripheral direction with respect to the optical axis (O); and/or
wherein at least some of the plurality of light beams (35) pass through the light exit surface (27) at different spacings from the optical axis (O); and/or wherein the plurality of light beams (35) are separate from one another; and/or
wherein the light beam generation device (31) is adapted to generate the plurality of light beams (35) such that the plurality of light beams (35) pass through the light exit surface (27) of the object simulation unit (21) at exit positions which are spaced apart from one another in order only to partly fill an entrance pupil of the respective camera objective (15) or which are at least substantially distributed over the total light exit surface (27) in order to at least substantially completely fill an entrance pupil of the respective camera objective (15).

7. An object simulation unit (21) in accordance with claim 5 or claim 6,
wherein each of the plurality of light sources (33) generates at least one of the plurality of light beams (35) and/or each of the plurality of light sources (33) generates a single one of the plurality of light beams (35).

8. An object simulation unit (21) in accordance with any one of the preceding claims,
wherein the plurality of light sources (33) are arranged within the same orthogonal plane with respect to the optical axis (O); and/or
wherein at least some of the plurality of light sources (33) are arranged distributed in the peripheral direction with respect to the optical axis (O).

9. An object simulation unit (21) in accordance with any one of the preceding claims,
wherein at least some of the plurality of light sources (33) are arranged at different spacings from the optical axis (O).

10. An object simulation unit (21) in accordance with any one of the preceding claims,
wherein the at least one virtual object (41) is disposed outside the object simulation unit (21); and/or
wherein the light beam generation device (31) comprises at least one diaphragm apparatus, with the diaphragm apparatus having at least one diaphragm aperture which is variable with respect to its opening width and/or position and which transmits portions of the light emitted by the at least one light source (33); and/or
wherein the at least one light source (33) emits white light; and/or
wherein the light beam generation device (31) is adapted to generate the at least one light beam (35) with one of a plurality of different selectable colors.

11. A diagnostic system (11) having an object simulation unit (21) in accordance with any one of the preceding claims and having an evaluation device (61) which is adapted to determine a degree of focus of an image of the at least one virtual object (41), which image is generated by the respective camera objective (15) coupled to the object simulation unit (21).

12. A diagnostic system (11) in accordance with claim 11,
wherein the diagnostic system (11) furthermore comprises an image recording apparatus (51), with the image recording apparatus (51) having a coupling device (53) which is adapted to couple a light entry side (55) of the image recording apparatus (51) to a light exit side (19) of the respective camera objective (15), and with the image recording apparatus (51) having an image sensor (57) for generating electrical image signals on the basis of an image of the virtual object (41) generated on the image sensor (57) by the respective camera objective (15);
wherein the evaluation device (61) is directly or indirectly connected or connectable to the image sensor (57); and
wherein the image recording apparatus (51) is preferably a video camera having an objective mount to which the light exit side (19) of the camera objective (15) is couplable.

13. A diagnostic system (11) in accordance with claim 11 or claim 12,
wherein the evaluation device (61) is adapted to determine the degree of focus of the image of the virtual object (41) on the basis of a blur pattern;
wherein the evaluation device (61) is preferably adapted to determine the degree of focus on the basis of a parameter of the blur pattern and/or on the basis of an edge blur of the blur pattern; and/or wherein the image of the at least one virtual object (41) comprises one or more light spots (67).

14. A diagnostic system (11) in accordance with any one of the claims 11 to 13,
wherein the evaluation device (61) is adapted to determine a maximum degree of focus of the image of the virtual object (41) for different distance setting values set at the camera objective (15);
wherein the evaluation device (61) is furthermore adapted to determine at least one correction value on the basis of a distance value of the virtual object (41) which corresponds to a distance of the virtual object (41) predefined by the object simulation unit (21) and on the basis of a distance setting value which is set at the camera objective (15) and which corresponds to the determined maximum degree of focus of the image, said correction value representing a difference between the distance value of the virtual object (41) and the distance setting value of the camera objective (15); and
wherein the evaluation device (61) is preferably adapted to determine a respective correction value for different distance values of the virtual object (41) set at the object simulation unit (21) and/or to determine the thickness of a spacer compensating the difference on the basis of the determined correction value, said spacer being provided for insertion between the respective camera objective (15) and a camera, between the respective camera objective (15) and an objective mount connectable to a camera or between an objective mount connectable to the camera and the camera.

15. A diagnostic system (11) in accordance with claim 14,
wherein the evaluation device (61) is couplable to a focal adjustment apparatus of an electrically adjustable camera objective (15); and
wherein the evaluation device (61) is adapted to transmit a focal correction value determined on the basis of the determined correction value or values to the focal adjustment apparatus; and/or
wherein the evaluation device (61) is adapted to determine the correction value or values in dependence on
- a diaphragm value set at the camera objective (15); and/or
- a focal length of the camera objective (15); and/or
- a total aperture of the at least one light beam (35) generated by the light beam generation device (31) and entering into the camera objective (15); and/or
- a color of the at least one light beam (35).

## Revendications

1. Appareil de simulation d'objet (21) pour tester un objectif de caméra (15), l'appareil de simulation d'objet (21) ayant un axe optique (O) et une face avant (23) à une extrémité par rapport à l'axe optique (O), comprenant :
une surface de sortie de lumière (27) sur la face avant (23) de l'appareil de simulation d'objet (21) ;
un moyen de couplage (29) qui est adapté pour coupler la face avant (23) de l'appareil de simulation d'objet (21) à une face d'entrée de lumière d'un objectif de caméra respectif (15) ; et
un moyen de génération de faisceau lumineux (31) qui comprend au moins une source de lumière (33) et qui est adapté pour générer au moins un faisceau lumineux (35) traversant ladite surface de sortie de lumière (27) de telle sorte que ledit au moins un faisceau lumineux (35) semble émaner d'au moins un objet virtuel (41) situé à une distance de ladite surface de sortie de lumière (27) qui est supérieure à la distance entre ledit moyen de génération de faisceau lumineux (31) et ladite surface de sortie de lumière (27),
**caractérisé en ce que**
le moyen de génération de faisceau lumineux (31) comprend plusieurs sources de lumière (33),
dans lequel
- la position et/ou l'orientation desdites plusieurs sources de lumière (33) sont réglables de telle sorte que, par réglage desdites plusieurs sources de lumière (33), la distance entre l'objet virtuel (41) et la surface de sortie de lumière (27) de l'appareil de simulation d'objet (21) est variable ; et/ou
- le moyen de génération de faisceau lumineux (31) comprend en outre plusieurs éléments d'imagerie (65), chacune desdites plusieurs sources de lumière (33) étant associée à l'un au moins desdits plusieurs éléments d'imagerie (65), la position et/ou l'orientation desdits plusieurs éléments d'imagerie (65) étant réglables de telle sorte que, par réglage desdits plusieurs éléments d'imagerie, la distance entre l'objet virtuel (41) et la surface de sortie de lumière (27) de l'appareil de simulation d'objet (21) est variable.

2. Appareil de simulation d'objet (21) selon la revendication 1,
dans lequel
l'objet virtuel (41) correspond au moins sensiblement à une source de lumière ponctuelle virtuelle ; ou
l'objet virtuel (41) correspond à une source de lumière virtuelle de forme linéaire qui s'étend à l'intérieur d'un plan orthogonal à l'axe optique (O) ; ou l'objet virtuel (41) correspond à une source de lumière virtuelle bidimen-sionnelle qui s'étend à l'intérieur d'un plan orthogonal à l'axe optique (O).

3. Appareil de simulation d'objet (21) selon la revendication 1 ou 2,
dans lequel
le moyen de génération de faisceau lumineux (31) est adapté pour générer successivement dans le temps un objet virtuel respectif (41) sur l'axe optique (O) à différentes distances par rapport à l'axe de sortie de lumière (37) de l'appareil de simulation d'objet (21) ; et/ou
le moyen de génération de faisceau lumineux (31) est adapté pour générer simultanément plusieurs objets virtuels (41) à l'intérieur d'un plan orthogonal à l'axe optique (O) ; et/ou
le moyen de génération de faisceau lumineux (31) est adapté pour générer simultanément plusieurs objets virtuels (41) à différentes distances latérales par rapport à l'axe optique (O).

4. Appareil de simulation d'objet (21) selon l'une des revendications précédentes,
dans lequel
ledit au moins un faisceau lumineux (35) traverse la surface de sortie de lumière (27) de l'appareil de simulation d'objet (21) suivant un axe de sortie de lumière (37) qui est incliné d'un angle de sortie par rapport à l'axe optique (O) de l'appareil de simulation d'objet (21), l'angle de sortie étant réglable ; et/ou
la distance latérale dudit au moins un objet virtuel (41) par rapport à l'axe optique (O) de l'appareil de simulation d'objet (21) est réglable.

5. Appareil de simulation d'objet (21) selon l'une des revendications précédentes,
dans lequel
le moyen de génération de faisceau lumineux (31) est adapté pour générer plusieurs faisceaux lumineux (35) qui traversent la source de sortie de lumière (27).

6. Appareil de simulation d'objet (21) selon la revendication 5,
dans lequel
lesdits plusieurs faisceaux lumineux (35) traversent la surface de sortie de lumière (27) de l'appareil de simulation d'objet (21) suivant un axe de sortie de lumière (37) respectif, les axes de sortie de lumière (37) étant orientés de telle sorte que lesdits plusieurs faisceaux lumineux (35) semblent émaner dudit au moins un objet virtuel (41) ; et/ou
quelques-uns au moins desdits plusieurs faisceaux lumineux (35) sont disposés en répartition en direction périphérique par rapport à l'axe optique (O) ; et/ou
quelques-uns au moins desdits plusieurs faisceaux lumineux (35) traversent la surface de sortie de lumière (27) à différentes distances par rapport à l'axe optique (O) ; et/ou
desdits plusieurs faisceau lumineux (35) sont séparés les uns des autres ; et/ou
le moyen de génération de faisceau lumineux (31) est adapté pour générer lesdits plusieurs faisceaux lumineux (35) de telle sorte que lesdits plusieurs faisceaux lumineux (35) traversent la surface de sortie de lumière (27) de l'appareil de simulation d'objet (21) à des emplacements de sortie qui sont espacés les uns des autres pour remplir seulement partiellement une pupille d'entrée de l'objectif de caméra (15) respectif, ou qui sont répartis au moins sensiblement sur la totalité de la surface de sortie de lumière (27) pour remplir au moins sensiblement complètement une pupille d'entrée de l'objectif de caméra (15) respectif.

7. Appareil de simulation d'objet (21) selon la revendication 5 ou 6,
dans lequel
chacune desdites plusieurs sources de lumière (33) génère l'un au moins desdits plusieurs faisceaux lumineux (35), et/ou chacune desdites plusieurs sources de lumière (33) génère un seul desdits plusieurs faisceaux lumineux (35).

8. Appareil de simulation d'objet (21) selon l'une des revendications précédentes,
dans lequel
lesdites plusieurs sources de lumière (33) sont disposées à l'intérieur du même plan orthogonal à l'axe optique (O) ; et/ou
quelques-unes au moins desdites plusieurs sources de lumière (33) sont disposées en répartition en direction périphérique par rapport à l'axe optique (O).

9. Appareil de simulation d'objet (21) selon l'une des revendications précédentes,
dans lequel
quelques-unes au moins desdites plusieurs sources de lumière (33) sont disposées à différentes distances par rapport à l'axe optique (O).

10. Appareil de simulation d'objet (21) selon l'une des revendications précédentes,
dans lequel
ledit au moins un objet virtuel (41) se situe à l'extérieur de l'appareil de simulation d'objet (21) ; et/ou
le moyen de génération de faisceau lumineux (31) comprend au moins un dispositif formant diaphragme, le dispositif formant diaphragme présentant au moins une ouverture de diaphragme variable par rapport à sa largeur d'ouverture et/ou à sa position, qui laisse passer des parties de la lumière émise par ladite au moins une source de lumière (33) ; et/ou
ladite au moins une source de lumière (33) émet une lumière blanche ; et/ou
le moyen de génération de faisceau lumineux (31) est adapté pour générer ledit au moins un faisceau lumineux (35) avec une parmi plusieurs couleurs différentes à choisir.

11. Système de diagnostic (11) comportant un appareil de simulation d'objet (21) selon l'une des revendications précédentes, comportant un moyen d'évaluation (61) qui est adapté pour déterminer un degré de mise au point d'une image dudit au moins un objet virtuel (41), ladite image étant générée par l'objectif de caméra (15) respectif couplé à l'appareil de simulation d'objet (21).

12. Système de diagnostic (11) selon la revendication 11,
dans lequel
le système de diagnostic (11) comprend en outre un dispositif d'acquisition d'image (51), le dispositif d'acquisition d'image (51) comprenant un moyen de couplage (53) qui est adapté pour coupler une face d'entrée de lumière (55) du dispositif d'acquisition d'image (51) à une face de sortie de lumière (19) de l'objectif de caméra (15) respectif, et le dispositif d'acquisition d'image (51) comprend un capteur d'image (57) pour générer des signaux d'image électriques en se basant sur une image de l'objet virtuel (41) générée par l'objectif de caméra (15) respectif sur le capteur d'image (57), le moyen d'évaluation (61) est connecté ou susceptible d'être connecté directement ou indirectement au capteur d'image (57) ;
le moyen d'acquisition d'image (51) est de préférence une caméra vidéo pourvue d'un support d'objet qui est susceptible d'être couplée à la face de sortie de lumière (19) de l'objectif de caméra (15).

13. Système de diagnostic (11) selon la revendication 11 ou 12,
dans lequel
le moyen d'évaluation (61) est adapté pour déterminer le degré de mise au point de l'image de l'objet virtuel (41) en se basant sur un motif de flou ;
le moyen d'évaluation (61) est de préférence adapté pour déterminer le degré de mise au point en se basant sur une taille du motif de flou et/ou en se basant sur un flou de bord du motif de flou ; et/ou
l'image dudit au moins un objet virtuel (41) comprend une ou plusieurs taches lumineuses (67).

14. Système de diagnostic (11) selon l'une des revendications 11 à 13, dans lequel
le moyen d'évaluation (61) est adapté pour déterminer un degré maximal de mise au point de l'image de l'objet virtuel (41) pour différentes valeurs de réglage de distance réglées sur l'objectif de caméra (15) ; et
le moyen d'évaluation (61) est en outre adapté pour déterminer au moins une valeur de correction en se basant sur une valeur de distance de l'objet virtuel (41) qui correspond à une distance de l'objet virtuel (41) prédéterminée par l'appareil de simulation d'objet (21), et en se basant sur une valeur de réglage de distance réglée sur l'objectif de caméra (15) et correspondant au degré maximal déterminé de mise au point de l'image, ladite valeur de correction représentant un écart entre la valeur de distance de l'objet virtuel (41) et la valeur de réglage de distance de l'objectif de caméra (15) ; et
le moyen d'évaluation (61) est de préférence adapté pour déterminer une valeur de correction respective pour différentes valeurs de distance de l'objet virtuel (41) réglées sur l'appareil de simulation d'objet (21) et/ou pour déterminer l'épaisseur d'un élément écarteur qui compense l'écart, en se basant sur la valeur de correction déterminée, ledit élément écarteur étant prévu pour être interposé entre l'objectif de caméra respectif (15) et une caméra, entre l'objectif de caméra respectif (15) et un support d'objectif susceptible d'être relié à une caméra, ou entre un support d'objectif susceptible d'être relié à une caméra et la caméra.

15. Système de diagnostic (11) selon la revendication 14,
dans lequel
le moyen d'évaluation (61) est susceptible d'être couplé à un dispositif de réglage de mise au point d'un objectif de caméra (15) réglable par voie électrique, et le moyen d'évaluation (61) est adapté pour transmettre une valeur de correction de mise au point au dispositif de réglage de mise au point en se basant sur la ou les valeurs de correction déterminées ; et/ou
le moyen d'évaluation (61) est adapté pour déterminer en outre la ou les valeurs de correction en fonction de
- une valeur de diaphragme réglée sur l'objectif de caméra (15), et/ou
- une distance focale de l'objectif de caméra (15), et/ou
- une ouverture globale pour ledit au moins un faisceau lumineux (35) généré par le moyen de génération de faisceau lumineux (31) et entrant dans l'objectif de caméra (15), et/ou
- une couleur dudit au moins un faisceau lumineux (35).
